Europäisches Patentamt

European Patent Office

Office européen des brevets

(11) Numéro de publication: **0 371 879**
**A1**

# (12) DEMANDE DE BREVET EUROPEEN

(21) Numéro de dépôt: 89403312.5

(22) Date de dépôt: 29.11.89

(51) Int. Cl.⁵: **A47B 51/00, B65G 1/10,** **H01L 21/00**

(30) Priorité: 01.12.88 FR 8815750

(43) Date de publication de la demande:
06.06.90 Bulletin 90/23

(84) Etats contractants désignés:
BE DE GB IT NL

(71) Demandeur: **COMMISSARIAT A L'ENERGIE ATOMIQUE**
**31/33, rue de la Fédération**
**F-75015 Paris(FR)**

(72) Inventeur: **Cruz, Didier**
**109 Cours Jean-Jaurès**
**F-38000 Grenoble(FR)**

(74) Mandataire: **Mongrédien, André et al**
**c/o BREVATOME 25, rue de Ponthieu**
**F-75008 Paris(FR)**

(54) Dispositif extensible de stockage d'objets plats.

(57) L'invention permet le stockage à volume réduit d'objets plats tout en permettant la manipulation des objets stockés.

Il est principalement constitué de supports latéraux réalisés sous la forme de lames métalliques pliées ou bombés de manière à définir un empilement de logements (4) dans chacun desquels un objet plat (2) et place. Grâce à l'élasticité des lames (10), l'empilement est extensible. Dans sa position naturelle de repos, l'empilement est rétracté ; cette position correspond à la position de stockage. Après étirement vers le haut de l'empilement, la hauteur des logements (4) est suffisamment importante pour permettre à un outil préhenseur de venir saisir ou remettre un objet plat (2), sans toucher aux objets adjacents.

Application au stockage des plaquettes de circuits intégrés.

FIG.7b

## DISPOSITIF EXTENSIBLE DE STOCKAGE D'OBJETS PLATS

Le domaine de la présente invention est le stockage d'objets plats, et en particulier le stockage de plaques circulaires en silicium, destinées à la fabrication des circuits intégrés.

Dans le domaine de la fabrication d'éléments micro-électroniques, on utilise des éléments de stockage standards, appelés "cassettes", positionnés sur les machines utilisées dans la fabrication des circuits intégrés. La capacité de stockage maximale de ces cassettes, ainsi que leurs caractéristiques géométriques principales sont définies par une norme internationale "SEMI ENGINEERING" basée sur le diamètre des plaques de silicium (4 ; 5 ; 6 ; 8 pouces, soit 101,6 ; 127 ; 152,4 ; 203,2 mm). Selon ces dispositifs de stockage de l'art antérieur, ces cassettes sont remplies par des lots de un à vingt-cinq plaques de silicium, placées et positionnées manuellement ou automatiquement sur les différentes machines entrant dans le processus de fabrication des circuits intégrés ou des "puces".

L'entraxe entre deux rayonnages, et donc entre deux plaques déposées sur une cassette standard, est extrêmement faible. En effet, pour des plaques de diamètre égal à 4 ; 5 ou 6 pouces, soit 101,6 ; 127 ou 152,4 mm, cette cote est fixée à 4,76 mm par la norme "SEMI ENGINEERING". L'étroitesse de cette cote rend extrêmement délicate la préhension d'une plaque stockée dans la cassette. En effet, tout système préhenseur doit pénétrer sous la plaque à prélever, sans rayer la face supérieure de la plaque située juste en-dessous de celle-ci. Conjointement, tout système préhenseur doit être suffisamment fin et guidé en translation de façon très précise pour éviter le contact destructeur précédemment décrit. Par conséquent, les difficultés technologiques inhérentes à ce problème prises en compte, les dispositifs préhenseurs construits jusqu'alors, et capables de prélever des plaques de façon unitaire, et avec des mouvements très précis sont donc très coûteux.

Le but de l'invention est de remédier à cet inconvénient, en proposant un autre type de dispositif de stockage de plaques de circuits intégrés.

A cet effet, l'objet principal de l'invention est un dispositif de stockage pour objets plats constitué d'un empilement de logements dans chacun desquels peut être placé un objet plat, chaque logement étant constitué d'au moins deux supports latéraux sur lesquels s'appuie un objet plat correspondant et d'au moins un espace libre entre les supports latéraux pour permettre à un outil préhenseur de venir entre les supports latéraux, pour prendre l'objet plat correspondant et le remettre par la suite, sans toucher un des deux objets plats adjacents.

Selon l'invention, l'empilement de logements est extensible dans la direction de l'empilement, par l'application de deux efforts antagonistes dans la direction de l'empilement, chacun des logements étant extensible par rapport aux deux logements adjacents, de façon à ce que l'empilement puisse par déformation élastique, prendre plusieurs positions, dont une première position dite de stockage, dans laquelle les logements se trouvent serrés les uns contre les autres avec, si possible, un entraxe répondant à la norme "SEMI ENGINEERING" pour une application microélectronique, et dont une dernière position, dite de manipulation, dans laquelle les logements sont espacés les uns des autres pour permettre aux outils préhenseurs de manipuler un objet sans toucher les objets adjacents.

Cette extension du dispositif de stockage est due au fait que les supports latéraux sont déformables élastiquement, leur position naturelle de repos correspondant à la première position dite de stockage de l'empilement.

De manière préférentielle, chaque support latéral est une lame mince, cylindrique, déformable, à génératrices horizontales et ayant une extrémité inférieure et une extrémité supérieure fixée chacune à une extrémité de la lame du logement adjacent.

Une deuxième réalisation prévoit que chaque support latéral est un rayonnage constitué d'au moins deux lames minces, cylindriques, déformables, à génératrices horizontales et cintrées de façon identique et ayant une extrémité inférieure et une extrémité supérieure fixée chacune à une extrémité de la lame adjacente du logement adjacent, les extrémités inférieures de chaque lame étant reliées entre elles par un fil support.

Chaque lame peut être pliée de façon à former un point de contact entre deux parties de la même lame, le point de contact faisant office de butée dans la position dite de stockage.

De manière préférentielle, et pour une application en microélectronique, les lames sont en acier inoxydable.

Les supports latéraux d'une même série peuvent être constitués d'une seule lame pour toute la série.

Une réalisation préférentielle du dispositif selon l'invention prévoit une platine inférieure fixée à une première extrémité inférieure de l'empilement et une platine supérieure fixée à une deuxième extrémité supérieure de l'empilement. Une réalisation du dispositif de stockage prévoit au moins deux colonnes rigides externes à l'empilement et destinées à assurer la rigidité de l'empilement, chaque colonne étant constituée d'une partie inférieure fixée à la platine inférieure et d'une partie supérieure fixée à la platine supérieure, la partie inférieure et la partie supérieure de chaque colonne étant en contact l'une de l'autre grâce à un centrage conique dans la position dite de stockage.

Les colonnes peuvent également être des soufflets métalliques, les supports latéraux étant constitués par des plaques fixes sur les spires des soufflets, qui comportent chacun une colonne interne télescopique pour assurer la rigidité des soufflets.

Dans une réalisation principale de l'invention, les deux efforts antagonistes sont fournis par les moyens moteurs d'extension comprenant un axe vertical solidaire de la platine supérieure et un moteur, fixe par rapport au milieu extérieur, pour faire translater l'axe vertical coulissant dans un palier fixé au moteur.

Les deux efforts antagonistes sont fournis de façon magnétique au moyen d'un bobinage fixé à une des deux parties de la colonne télescopique, alimenté par un générateur de courant pour faire translater la deuxième partie de la colonne télescopique.

On prévoit que l'extension de l'empilement puisse être limitée par des butées inférieure et supérieure, limitant ainsi la course de la platine supérieure.

Les butées peuvent être mécaniques, ou être réalisées à l'aide d'un détecteur fixe et de réflecteurs fixés sur la surface externe des supports latéraux.

L'invention et ses différentes caractéristiques techniques seront mieux comprises à la lecture de la description qui suit et qui est annexée des figures représentant respectivement :

- figures 1A et 1B, deux schémas relatifs au fonctionnement du dispositif selon l'invention ;
- figure 2, une vue partielle relative à une première réalisation des supports latéraux, sous forme de lames, utilisés dans le dispositif selon l'invention ;
- figure 3, une vue partielle d'une deuxième réalisation des lames utilisées dans le dispositif selon l'invention ;
- figures 4A et 4B, des vues partielles relatives à une troisième réalisation des lames utilisées dans le dispositif selon l'invention ;
- figures 5A et 5B, deux schémas relatifs à une réalisation du dispositif selon l'invention utilisant des colonnes externes ;
- figure 6, un schéma relatif à une deuxième réalisation du dispositif selon l'invention utilisant des colonnes externes ;
- figures 7A et 7B, des vues d'un dispositif selon l'invention et de ses moyens d'extension ;
- figures 8A et 8B, des schémas relatifs à une variante de fonctionnement du dispositif selon l'invention ;
- figure 9, un schéma relatif à un mode de réalisation d'une colonne externe utilisée dans le dispositif selon l'invention ;
- figures 10 et 11, des schémas relatifs à deux possibilités de réalisation de butée d'extension sur un dispositif selon l'invention.

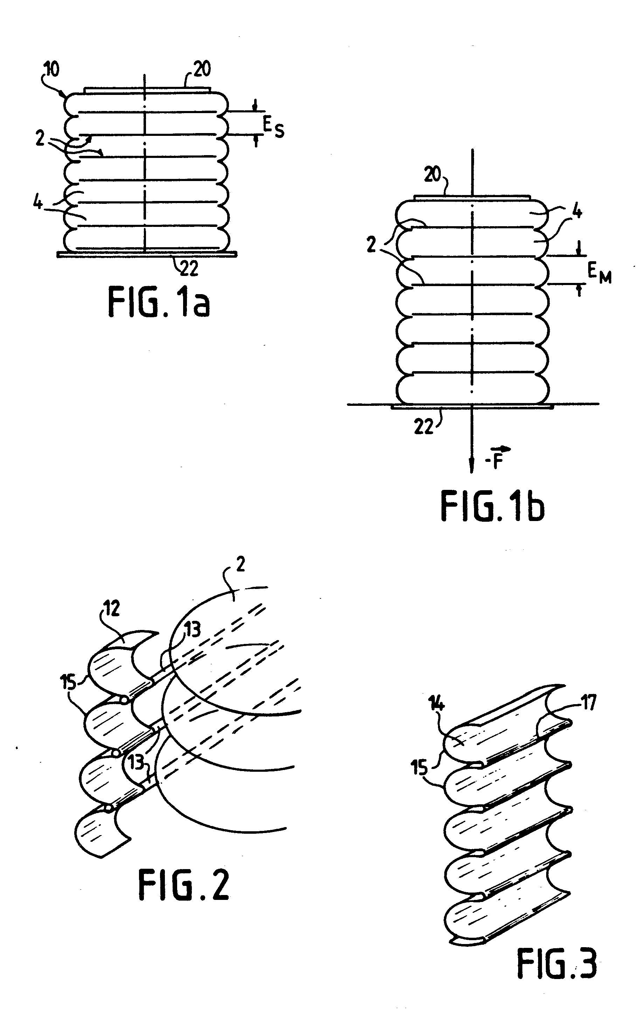

Le principe général de l'invention est exposé à l'aide des figures 1A et 1B.

Le dispositif de stockage est représenté sur la figure 1A en position de stockage. Sa structure définit un empilement de logements 4 dans chacun desquels est placé un objet plat 2, tel qu'une plaque circulaire de silicium destinée à supporter un circuit intégré. Les objets plats 2 sont séparés les uns des autres par un entraxe $E_S$ normalisé par la norme "SEMI ENGINEERING". Chaque objet plat 2 repose sur deux supports latéraux. De manière générale, dans la plupart des réalisations du dispositif selon l'invention, chaque support latéral est constitué de l'extrémité inférieure d'une lame 10 recourbée de manière à délimiter une extrémité d'un logement 4. Chaque extrémité inférieure d'une lame 10 est reliée à l'extrémité supérieure de la lame 10 qui est en dessous d'elle. L'ensemble de ces logements 4 est terminé par une platine supérieure 20 et une platine inférieure 22. Cette position de stockage est la position naturelle du dispositif, c'est-à-dire que l'empilement reste dans cette position sans l'apport d'une quelconque force extérieure.

Le principe du dispositif selon l'invention repose sur le fait que celui-ci est extensible. En effet, dans la position de stockage représentée sur la figure 1A, l'écart $E_S$ entre deux objets plats stockés 2 n'est pas suffisant pour permettre à un outil préhenseur de venir s'insérer entre les supports latéraux, et en particulier deux objets plats adjacents, pour saisir un de ces objets stockés 2.

Sur la figure 1B, le dispositif de stockage est représenté étiré dans une position dite position de manipulation. Grâce à l'élasticité des lames 10 constituant les deux supports latéraux, chaque logement 4 s'est en quelque sorte "épaissi", c'est-à-dire que l'écart entre deux objets plats 2 a augmenté pour prendre une valeur $E_M$, appelée écart de manipulation. Cet écart $E_M$ permet, cette fois-ci, à un outil préhenseur de venir s'insérer entre les objets plats 2 pour en saisir au moins un sans toucher les autres. L'étirement est obtenu grâce à des forces F appliquées aux deux platines supérieure 20 et inférieure 22, dans des directions verticales et opposées.

Une première réalisation des supports latéraux est représentée sur la figure 2. Chaque support latéral peut donc être composé de deux minces lames 12 reliées l'une à l'autre par un jeu de fils 13 rigides, tous ces éléments pouvant être en acier et constituent un rayonnage pouvant supporter un objet plat. Les deux lames minces 12 peuvent être cintrées ou pliées de manière à former plusieurs secteurs cylindriques à génératrices horizontales 15 entre lesquel les les fils 13 viennent s'encastrer, la série de pliures 15 de chaque lame 12 étant alignée et formant une série de supports latéraux superposés. Les deux supports latéraux ainsi confectionnés sont mis face à face, écartés d'une distance telle que des objets plats, de préférence cylindriques, puissent prendre appui sur les fils 13, tout en y étant introduits par la concavité de chaque secteur cylindrique 15. Les deux lignes formées par les sommets de chaque pliure 15 des deux supports latéraux sont écartées l'une de l'autre d'une distance supérieure au diamètre des objets plats circulaires 2. Les fils 13 peuvent être collés ou soudés aux lames 12.

Cette première conception de réalisation du dispositif de stockage possède une rigidité intrinsèque. C'est-à-dire, qu'à l'état naturel, qui correspond à la position de stockage, les supports latéraux, constituant des colonnes déformables, assurent au dispositif de stockage sa rigidité.

Les lames 12 peuvent être constituées en acier inoxydable, ou en un autre matériau élastique.

En référence à la figure 3, une deuxième réalisation des supports latéraux consiste à utiliser une seule lame 14 de grande largeur, correspondant à la profondeur du dispositif de stockage. Cette unique lame 14 remplace les deux lames 12 de la figure 2, ainsi que les fils 13 destinés à supporter les objets plats 2. Cette lame large 14 peut avoir la même forme qu'une série de lames 12, c'est-à-dire des secteurs cylindriques 15 réunis par une pliure brusque continue 17, remplaçant le fil 13 de la figure 2, et faisant office des supports des objets plats 2.

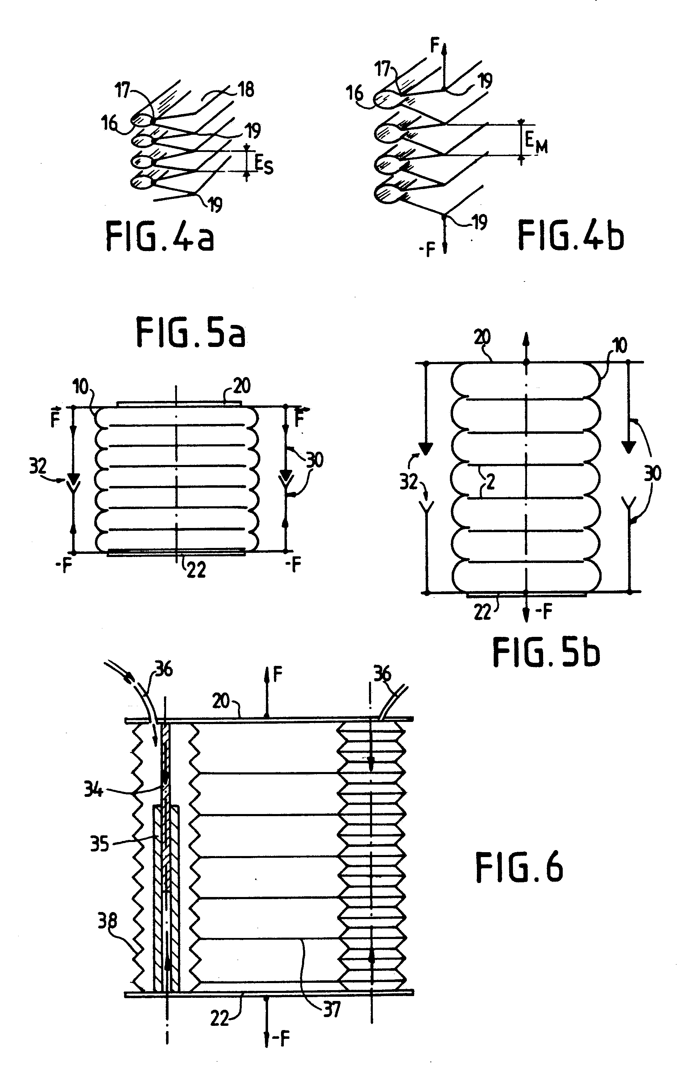

La troisième réalisation des supports latéraux, représentée par les figures 4A et 4B, est un peu différente des deux premières. La lame constituant un support, comporte toujours les secteurs cylindriques 16. Par contre, les extrémités de chaque secteur cylindrique 16 se touchent en un point 17, lorsque le dispositif est en position de stockage, comme représenté sur la figure 4A. La lame se prolonge, après les extrémités de ce secteur cylindrique 16 par des parties planes 18, chaque partie plane 18 rejoignant la partie plane d'une pliure adjacente par une pliure brusque 19, faisant office de support pour un objet plat.

Pour mettre le dispositif de stockage en position de manipulation, on applique aux extrémités de celui-ci deux forces F antagonistes semblables à celles évoquées pour les deux premières réalisations, telles que représentées sur la figure 4B. Sous l'effet de ces deux forces F, la lame s'étire, de manière à ce que l'écart de stockage $E_S$ entre deux pliures supports 19 figurant sur la figure 4A, prennent une valeur $E_M$ égale à l'écart de manipulation précédemment évoqué. Dans cette position, les points 17 qui étaient en contact dans la position de stockage sont alors séparés les uns des autres. Cet étirement est toujours dû à l'élasticité de la lame. Une telle lame est précontrainte, de manière à ce que son état naturel soit la position de stockage décrite par la figure 4A. Cette dernière réalisation d'un empilement a une meilleure rigidité à l'état naturel que les deux réalisations précédentes.

Les trois réalisations de supports latéraux décrites dans les paragraphes précédents, constituent des dispositifs de stockage à rigidité intrinsèque. C'est-à-dire que l'empilement, compose principalement de ces supports latéraux, a une structure telle que, à l'état naturel, il assure lui-même sa propre rigidité. Chaque support latéral d'une série peut être réalisé par une lame unique, pliée plusieurs fois, et servant pour chaque logement de la série.

Un deuxième type de dispositif de stockage est celui du type à rigidité externe. En effet, dans ce cas, on utilise des colonnes externes assurant la stabilité de l'empilement.

Les figures 5A et 5B représentent une première réalisation de ce type de dispositif de stockage.

Dans ce cas, des colonnes auxiliaires 30 sont disposées à l'extérieur de l'empilement des logements 4 constitués par des supports latéraux. Elles sont de préférence au nombre de quatre, sont positionnées près des supports latéraux et sont fixes aux platines supérieure 20 et inférieure 22.

Les colonnes externes 30 sont maintenues en contact par la traction plastique de l'empilement déformable, dont la position naturelle est la position de stockage.

La figure 5B illustre l'étirement de l'empilement, toujours à l'aide de deux efforts F antagonistes appliqués aux platines supérieure 20 et inférieure 22. Dans ce cas, les deux éléments de chaque colonne externe 30 ne sont plus en contact, la stabilité du système de stockage étant alors assurée par les deux efforts F.

Le principal avantage de ce type de dispositif de stockage est sa rigidité par rapport aux réalisations décrites précédemment.

Dans la deuxième réalisation du dispositif de stockage selon l'invention utilisant des colonnes externes et décrites sur la figure 6, les colonnes externes sont des colonnes télescopiques. Elles sont constituées principalement de deux éléments de guidage, un premier 34 solidaire de la platine supérieure et un deuxième 35 solidaire de la platine inférieure 22. L'un des deux, en l'occurrence 34, est constitué d'une tige qui pénètre à l'intérieur du deuxième 35, constitué d'un tube ajusté au diamètre du premier élément 34. Cet ensemble de coulissement est entouré du soufflet 38, alimenté par une arrivée d'air 36, placée par exemple sur la platine supérieure 20. La rigidité des soufflets est assurée par l'interpénétration et le glissement relatif des deux éléments 34 et 35 de la colonne de guidage télescopique, placée à l'intérieur de ce soufflet 38. Cette réalisation, bien que mettant en mouvements relatifs des éléments mécaniques, ne pollue pas les objets plats stockés. En effet, les particules émises par frottement de glissement des deux éléments 34 et 35 des colonnes télescopiques de guidage, lors du changement de géométrie du dispositif de stockage, sont confinées à l'intérieur du soufflet 38 de chaque colonne télescopique.

Les soufflets 38 peuvent être métalliques. Ils sont étanchés par soudage ou collage sur les platines supérieure 20 ou inférieure 22.

A l'état naturel, qui est la position de stockage, la géométrie du dispositif est garantie par la traction qu'exercent les soufflets 38 sur les colonnes de guidage. Cette position de stockage peut être définie au moyen des éléments 34 et 35 des colonnes de guidage qui peuvent se trouver en butée mécanique.

Dans cette réalisation, les supports latéraux sont constitués par les soufflets 38 et des rayonnages qui peuvent être des plaques 37, en forme de secteur de couronne, soudées ou collées sur les spires des soufflets 38.

On comprend qu'une simple mise en pression des soufflets 38 assure le changement de géométrie du dispositif de stockage, celui-ci passant de la position de stockage à la position de manipulation. Inversement, une suppression de la pression permet au dispositif de retrouver la position de stockage par élasticité naturelle.

Cette réalisation a pour avantage une rigidité assurée quel le que soit la position donnée au dispositif, et en particulier en ce qui concerne des éventuelles positions intermédiaires entre la position de stockage et la position de manipulation.

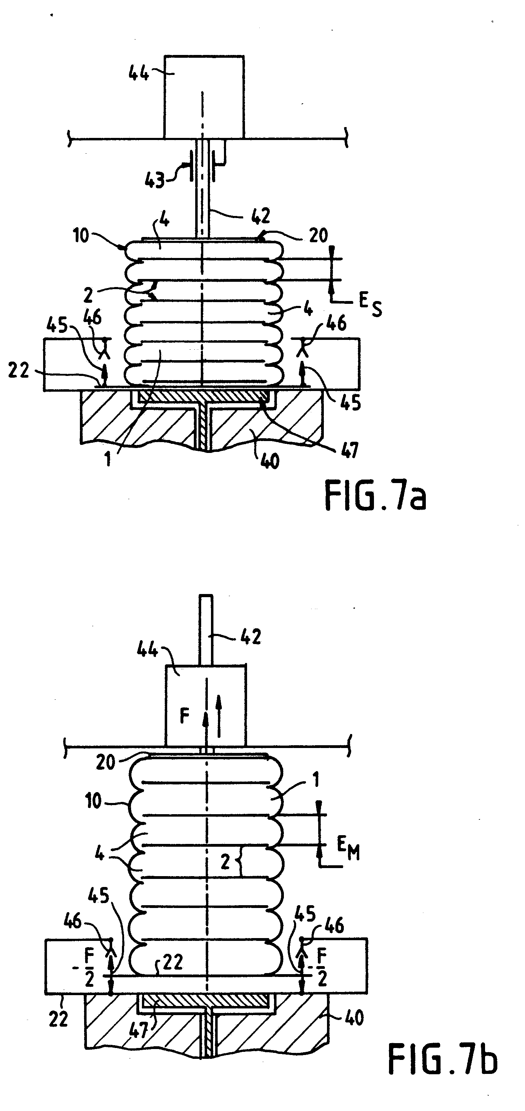

Les figures 7A et 7B montrent l'infrastructure nécessaire au fonctionnement du dispositif de stockage selon l'invention.

Le dispositif de stockage est représenté installé sur une machine symbolisée par son bâti 40. Cette machine est complétée par un outil préhenseur, non représenté, dont la fonction est de saisir les objets plats stockés 2, pour les amener à un poste de travail situé sur la machine. Le dispositif de stockage est posé sur une embase 47 se trouvant sur le bâti 40 de la machine. Des moyens de motorisation 44 sont fixés sur le bâti de la machine. De manière plus précise, ces moyens de motorisation 44 entrainent en translation un axe vertical 42, au moyen d'un palier 43. L'axe vertical 42 est fixé, à sa partie inférieure, à la platine supérieure 20 du dispositif de stockage. Lorsque les moyens de motorisation 44 agissent sur l'axe vertical 42, quand le dispositif de stockage est en position dite de stockage, l'axe vertical 42 monte et étire l'empilement de logements 4. La hauteur $E_S$ des espaces 4 dans lesquels sont logés les objets plats augmente, pour prendre la valeur $E_M$ de manipulation.

Pour permettre cet étirement, la platine inférieure 22 est fixée sur le bâti de la machine 40. Cette fixation peut être réalisée à l'aide de pions de cent rage 45 fixés sur cette platine inférieure 22, à l'extérieur de l'empilement, chacun étant dirigé vers le haut, en coincidence avec une partie femelle 46 correspondante fixée au bâti 40. Comme ces deux éléments 45 et 46 sont rapprochés lorsque le dispositif est en position de stockage, la moindre traction vers le haut appliquée à la platine supérieure 20 fait décoller la platine inférieure 22, mettant en contact, et donc en butée, les pions de cent rage dans les parties femelles correspondantes 46. L'empilement est ainsi bloqué à sa base, par l'intermédiaire de la platine inférieure 22, et son étirement peut avoir lieu. L'étirement est toujours obtenu grâce à l'élasticité des colonnes déformables ou supports latéraux, constitués ici par des lames élastiques 10, telles que décrites dans les figures 1 à 4. Un mouvement inverse de l'axe vertical 42 aboutit à la redescente de la platine supérieure 20, donc au retour du dispositif à sa position de stockage.

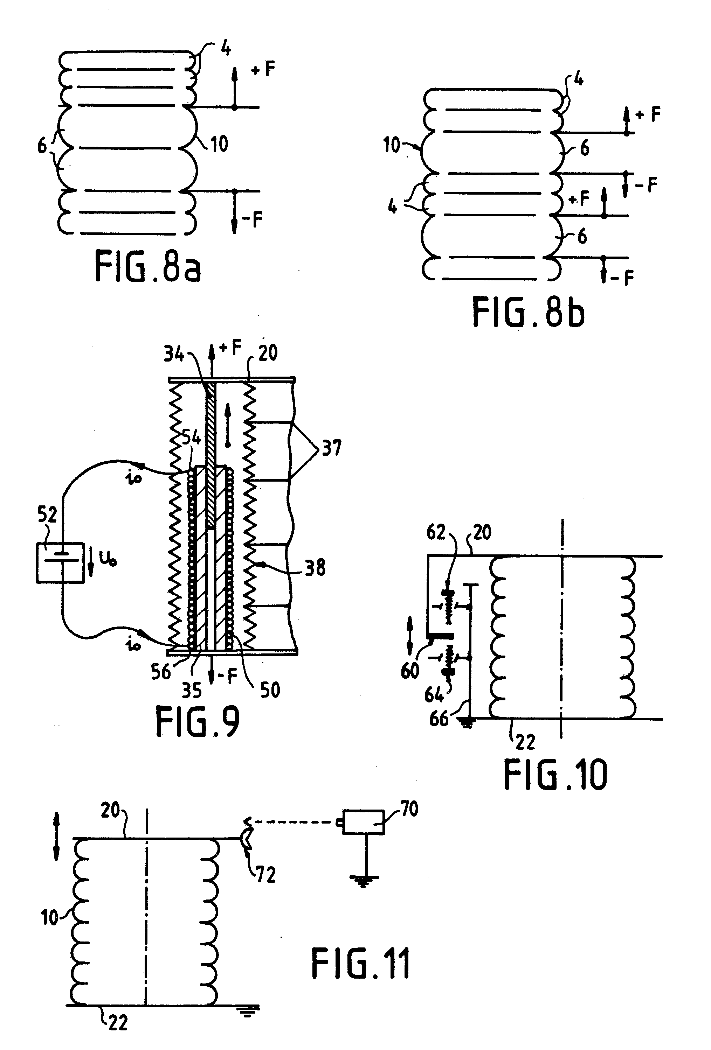

En référence aux figures 8A et 8B, le dispositif de stockage selon l'invention peut fonctionner d'une manière différente de celle décrite précédemment. Il est en effet utile de n'avoir accès qu'à un ou certains logements 6 parmi l'ensemble des logements 4 d'un empilement. Par exemple, si seulement deux objets plats à stocker dans un dispositif de stockage comprenant une vingtaine de logements, c'est-à-dire renfermant une vingtaine d'objets plats, doivent être sortis du dispositif de stockage, il n'est pas nécessaire d'étirer l'ensemble de l'empilement. On peut a lors envisager de n'appliquer les efforts antagonistes F qu'aux logements concernés 6, afin d'obtenir l'étirement de ces logements, sans pour cela agir sur les autres logements 4.

La figure 8A montre ces efforts F appliqués aux deux extrémités d'un ensemble de deux logements 6 devant être étirés, cet ensemble étant place au milieu de l'empilement. La structure du dispositif de stockage selon l'invention permet cette variante de fonctionnement. De façon similaire, la figure 8B montre que plusieurs couples d'effort F peuvent être appliqués à des endroits différents de l'empilement, afin de n'étirer que certains logements 6 séparés les uns des autres par des logements 4 qui ne doivent pas être étirés. Il est donc permis d'envisager un système d'application des efforts en fonction de la sélection des logements à étirer.

La figure 9 montre des moyens de commande de la déformation d'une colonne externe à soufflets, mais n'utilisant pas de moyens pneumatiques. Ces derniers sont remplacés par des moyens électromagnétiques. Cette réalisation consiste principalement à équiper ledit tube 35 de la colonne télescopique, placée à l'intérieur du soufflet 38, d'un bobinage de commande 50 enroulé autour de ce tube 35. Les extrémités 54 et 56 du bobinage de commande 50 sont reliées à un générateur de courant 52. Sous l'action d'un courant i, le champ magnétique créé par le bobinage au centre de celui-ci repousse la tige 34 de la colonne télescopique vers le haut, entraînant ainsi la platine supérieure 20, afin d'obtenir l'étirement de l'empilement. Le mouvement d'étirement peut être stoppé mécaniquement par n'importe quel système de butée.

La coupure de courant i entraîne la coupure du champ magnétique de commande de la colonne télescopique, et la redescente de celle-ci dans la position dite de stockage. Cette redescente est provoquée par la réaction du soufflet 38 qui a tendance à revenir dans sa position naturelle de repos.

En se référant aux figures 10 et 11, il est possible de limiter l'amplitude de l'étirement de l'empilement, en disposant un système de butées appliqué à la platine supérieure 20. Par exemple, un montant 66, fixe par rapport à la platine inférieure 22, peut être disposé le long de l'empilement. Des butées peuvent être installées de façon réglable sur ce montant 66 sous la forme de vis 62 et 64 montées face à face, un certain écart les séparant. Cet écart définit l'amplitude de l'étirement de l'empilement, en limitant le déplacement d'un élément de butée 60 entre les deux vis 62 et 64. Cet élément de butée 60 est solidaire de la platine supérieure 20. Les vis 62 et 64 étant montées réglagles vis-à-vis du montant fixe 66, l'étirement de l'empilement est également réglable.

La figure 11 montre une version optique d'une possibilité de réglage de l'extension de l'empilement. Dans ce but, un réflecteur 72 est monté solidaire de la platine supérieure 20, sa partie opérationnelle étant orientée en direction d'un détecteur 70 émettant un faisceau de détection. Pour la position correspondant à la position d'étirement choisie de l'empilement, le réflecteur 72 renvoie le faisceau sur le détecteur 70. Ce dernier est fixe par rapport à la platine inférieure 22. Il agit sur le système de commande de la déformation de l'empilement.

La présente invention a été décrite sous plusieurs formes, d'autres réalisations étant envisageables, sans pour cela sortir du cadre de la présente invention.

## Revendications

1. Dispositif de stockage pour objets plats constitués d'un empilement de logements (4) dans chacun desquels peut être place un objet plat (2), chaque logement étant constitue d'au moins :
- deux supports latéraux sur lesquels s'appuie un objet plat correspondant (2) ; et
- un espace libre entre les supports latéraux et entre les objets plats (2), pour permettre à un outil préhenseur de venir entre les supports latéraux pour prendre l'objet plat correspondant (2), et le remettre par la suite sans toucher un des deux objets plats adjacents (2), caractérisé en ce que l'empilement de logements (4) est extensible dans la direction de l'empilement, par l'application de deux efforts antagonistes (F) dans la direction de l'empilement, chacun des logements (4) étant extensible par rapport aux deux logements adjacents, de façon à ce que l'empilement puisse, par déformation élastique, prendre plusieurs positions, dont une première position dite de stockage dans laquelle les logements (4) se trouvent serrés les uns contre les autres et, dont une dernière position dite de manipulation dans laquelle les logements (4) sont espacés les uns des autres pour permettre à l'outil préhenseur de manipuler un objet (2) sans toucher un des deux objets adjacents (2).

2. Dispositif de stockage selon la revendication 1, caractérisé en ce que les supports latéraux étant déformables élastiquement, leur position naturelle de repos correspond à la première position dite de stockage de l'empilement.

3. Dispositif de stockage selon la revendication 1, caractérisé en ce que chaque support latéral est une lame (14) mince, cylindrique, déformable, à génératrices horizontales et ayant une extrémité inférieure et une extrémité supérieure fixées chacune à une extrémité de la lame du logement adjacent.

4. Dispositif de stockage selon la revendication 1, caractérise en ce que chaque support latéral est un rayonnage constitué d'au moins deux lames (12) minces, cylindriques, déformables, à génératrices horizontales et cintrées de façon identique et ayant une extrémité inférieure et une extrémité supérieure fixées chacune à une extrémité de la lame adjacente, les extrémités inférieures de chaque lame (12) étant reliées entre elles par un fil support (13).

5. Dispositif de stockage selon la revendication 3, caractérisé en ce que chaque lame peut être pliée de façon à former un point de contact (17) entre deux parties de la même lame, le point de contact (17) faisant office de butée dans la position dite de stockage.

6. Dispositif de stockage selon l'une quelconque des revendications 2 à 5, caractérisé en ce que les lames (10, 12, 14) sont en acier inoxydable.

7. Dispositif de stockage selon l'une quelconque des revendications 2 à 5, caractérisé en ce que les supports latéraux d'une même série sont constitués d'une seule lame pour toute la série.

8. Dispositif de stockage selon la revendication 1, caractérisé en ce qu'une platine supérieure (20) est fixée à l'extrémité supérieure de l'empilement et une platine inférieure (22) est fixée à l'extrémité inférieure de l'empilement.

9. Dispositif de stockage selon la revendication 8, caractérisé en ce qu'il comprend au moins deux colonnes rigides (30) externes à l'empilement et destinées à assurer la rigidité de l'empilement, chaque colonne (30) étant constituée d'une partie supérieure fixée à la platine supérieure (20) et une partie inférieure fixée à la platine inférieure (22), ces deux parties supérieure et inférieure étant en contact l'une de l'autre à la position dite de stockage, au moyen d'un système de centrage conique (32).

10. Dispositif de stockage selon la revendication 1, caractérisé en ce qu'il comprend au moins deux colonnes externes constituées de soufflets métalliques (38), les supports latéraux étant constitués par des plaques (37) fixes sur les spires des soufflets (38), qui comportent chacun une colonne interne télescopique pour assurer la rigidité des soufflets (38), et de l'empilement.

11. Dispositif de stockage selon la revendication 8, caractérisé en ce que les deux efforts antagonistes (F) sont fournis par des moyens moteurs d'extension comprenant un axe vertical (42) solidaire de la platine supérieure (20) et un moteur (44) fixe par rapport au milieu extérieur, pour faire translater ledit axe (42) coulissant dans un palier (43) fixé au moteur (44).

12. Dispositif de stockage selon la revendication 10, caractéri en ce que les efforts antagonistes (F) sont fournis de façon magnétique au moyen d'un bobinage (50) fixé à une des deux parties (35) de la colonne télescopique et alimenté par un générateur de courant (52) pour faire translater la deuxième partie (34) de la colonne télescopique.

13. Dispositif de stockage selon la revendication 8, caractérisé en ce que l'extension de l'empilement est limitée par des butées supérieure (62) et inférieure (64) limitant la course de la platine supérieure (20).

14. Dispositif de stockage selon la revendication 13, caractérisé en ce que les butées (62, 64) sont mécaniques.

15. Dispositif de stockage selon la revendication 13, caractérisé en ce que les butées sont réalisées à l'aide d'un détecteur (70) fixe et au moins un réflecteur (72) fixé sur la surface externe d'un des supports latéraux.

FIG.1a

FIG.1b

FIG.2

FIG.3

FIG.4a

FIG.4b

FIG.5a

FIG.5b

FIG.6

FIG.7a

FIG.7b

FIG.8a

FIG.8b

FIG.9

FIG.10

FIG.11

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-C- 471 334 (BREBION)<br>* le document entier *<br>--- | 1 | A 47 B   51/00<br>B 65 G    1/10<br>H 01 L   21/00 |
| A | GB-A-2 144 718 (KULICKE AND SOFFA)<br>* page 1, lignes 5-22; figures 1-3 *<br>--- | 1 | |
| A | US-A-3 902 615 (LEVY et al.)<br>* figures 3,4 *<br>--- | 1 | |
| A | GB-A-2 040 269 (A.J. PANTING)<br>* PAGE +; LIGNES %_&ç; figures 1,2 *<br>--- | 1 | |
| A | US-A-3 616 941 (WALLING)<br>* colonne 2, ligne 36 - colonne 3,<br>ligne 17; figures 3-5 *<br>----- | 1 | |

|  | DOMAINES TECHNIQUES RECHERCHES (Int. Cl.5) |
|---|---|
|  | A 47 B<br>B 65 G<br>H 01 L |

Le présent rapport a été établi pour toutes les revendications

| Lieu de la recherche | Date d'achèvement de la recherche | Examinateur |
|---|---|---|
| BERLIN | 12-02-1990 | SIMON J J P |

EPO FORM 1503 03.82 (P0402)